# EUROPEAN PATENT APPLICATION

(11) **EP 3 859 913 A1**
(43) Date of publication of application: **04.08.2021**
(21) Application number: 21153642.0
(22) Date of filing: 27.01.2021
(51) Int. Cl.: H01S 5/0687, H01S 5/02, H01S 5/183

(54) **TUNABLE LASER ASSEMBLY**

(30) Priority: 30.01.2020 US 202062967926 P
(71) Applicant: Thorlabs Quantum Electronics, Inc., Jessup, MD 20794 (US)
(72) Inventor: Heim, Peter J.S., Jessup, MD 20794 (US); Donaldson, Alan, Jessup, Maryland, 20794 (US); Mertz, Jacob, Jessup, MD 20794 (US); Roche, Robert, Jessup, Maryland, 20794 (US)
(74) Representative: Grättinger Möhring von Poschinger Patentanwälte Partnerschaft mbB

(57) **Abstract**

A tunable laser assembly housed in a single enclosure and a method of control is described that provides high-speed monitoring and control of the spectral properties of widely tunable lasers, such as MEMS-tunable VCSELs, with an optical configuration that does not introduce perturbations into the swept-source laser output spectrum that would cause artifacts in imaging applications such as optical coherence tomography (OCT).

## Description

### CROSS REFERENCE TO RELATED APPLICATIONS

This application claims the benefit of U.S. Provisional Patent Application No. 62/967,926 filed on January 30, 2020. The disclosure of U.S. Provisional Patent Application 62/967,926 is hereby incorporated by reference.

### FIELD OF THE INVENTION

This invention relates generally to tunable semiconductor lasers, and more particularly to the wavelength monitoring and control of tunable semiconductor lasers.

### BACKGROUND

Tunable lasers are critical components in many optical imaging and optical sensing systems. High output power, broad tuning, and extremely pure and stable spectral characteristics are required for high-performance systems. Vertical cavity semiconductor lasers (VCSELs) have proven to be good sources for these applications due to their single-frequency, mode-hop-free tuning characteristics which provide for long coherence length laser output. VCSELs differentiate themselves from other types of tunable semiconductor lasers in that the cavity length of the VCSEL is short enough that only one longitudinal mode under the gain curve is available for lasing. This is in comparison with in-plane, edge-emitting tunable lasers where multiple longitudinal modes exist under the gain curve requiring wavelength selective elements to select lasing only one longitudinal mode. The use of light-weight micro-electro-mechanical system (MEMS) tuning elements enable high-sweep rates e.g., 10 kHz to > 1 MHz over broad tuning ranges e.g., 10 nm to >100 nm. VCSELs are also attractive because they are scalable to wafer-level manufacturing and therefore lower cost. Operating wavelengths can include a very wide range, based only upon the availability of semiconductor gain elements and optical Bragg grating reflectors, ranging from ultraviolet (UV), e.g., 250 nm out to many microns, e.g., > 5 microns.

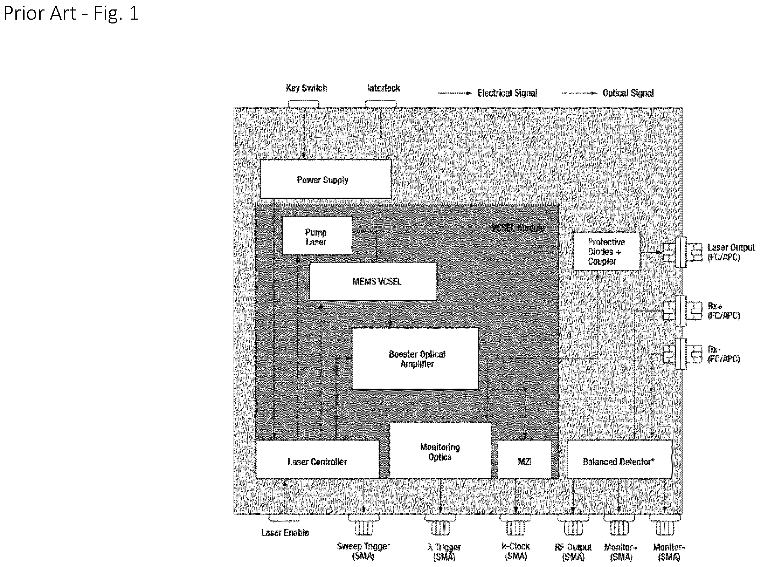

Implementation of the optical imaging or optical sensing system requires accurate knowledge of the tunable laser wavelength as it sweeps over its tuning range. Many methods have been used to characterize the tunable laser wavelength, including multi-point calibration [1], built-in wavelength meters [2], bandpass filter arrays [3], wavelength discriminator arrays [4], wavelength-to-power calibration [5], etalons [6, 7], position sensitive detectors, [8], arrayed waveguide gratings [9] and a series of fiber Bragg gratings [10]. These methods acknowledge that the wavelength tuning characteristics of the tunable laser will vary over time responding to environmental (e.g., temperature, pressure) and aging effects. There can also be short-term sweep-to-sweep variations due to inherent electro-mechanical properties of the tuning elements. Moreover, instantaneous characterization of wavelength becomes more difficult as the sweep rate increases. Modern optical imaging systems, for example such as those used in optical coherence tomography (OCT), employ interferometers to measure the instantaneous laser wavelength. The output from the interferometer interfaces with high-speed data acquisition system enabling compensation for any short-term variations in the laser spectral sweep characteristics. However, it is important that the overall spectral properties of the laser output e.g., center wavelength, optical bandwidth, and spectral shape, remain constant over the operating environment and lifetime of the laser. A typical approach for monitoring and controlling the center wavelength is to use a fiber bragg grating (FBG) with a single reflection peak in the vicinity of the center wavelength [11]. This provides a reference wavelength that is used as a 'λ-trigger' which often more stable for triggering the data acquisition than an electronic 'sweep trigger' (FIG. 1). One disadvantage of an FBG, in addition to size and cost, is that the FBG is not stable over temperature, it drifts with ∼ 10 pm/C rate, which is not desirable for a wavelength reference.

The optical output power from single-spatial mode tunable VCSELs is limited by the small cavity size and thermal properties of the semiconductor epitaxial layer structure. Output power in the range of 50 mW or greater are required, particularly to achieve desired signal-to-noise sensitivity as the sweep rate increase to speeds in excess of >100 kHz. High output power from the tunable laser also reduces overall system costs by enabling lower cost components and assembly techniques downstream of the tunable laser. For these reasons, it is necessary to increase the output power from the VCSEL using an optical amplifier.

Low cost is also an essential element to enable optical imaging and sensing applications in higher volume consumer markets such as robotic machine vision, autonomous driving, and home health care OCT applications.

The following novel concepts according to embodiments of the present invention provide a highly stable, low cost, tunable laser assembly based on VCSELs, semiconductor optical amplifiers and bulk optical components including optical filters and etalons. The concepts are applicable to both optically-pumped and electrically- pumped VCSELs

### SUMMARY

To enable the wide-spread adoption of swept-source laser imaging, Lidar, and metrology applications in such areas as home health care OCT, autonomous driving, and robotic machine vision, the cost of the swept-source laser must be significantly reduced. The primary method for reducing cost in optoelectronic components is through optoelectronic integration of as many sub-components as possible on a common packaging platform. The majority of optoelectronic component cost is not in the semiconductor chip itself, but in the manufacturing process and sub-components that align, attach and ultimately couple light into the end-user optical fiber. Expensive hermetically sealed, temperature controlled, gold-plated packages must contain as many components and functions as possible to amortize the cost of the gold -plated packages and thermo-electric coolers (TECs).

Integration of various optoelectronics components also presents unique challenges in terms of compromises in performance in order to achieve reduced size and cost. In the case of swept-source lasers, integrated wavelength monitoring control functions must be accomplished without introducing perturbation to the swept-source laser output spectrum that cause artifacts in the final system measurement and/or image. OCT imaging systems, for example, are sensitive to reflections in the optical path that produce parasitic etalons causing artifacts that are 50 dB or more below the main signal.

One embodiment of the present invention provides a tunable laser assembly housed in a single enclosure wherein the center wavelength and tuning bandwidth of the tunable VCSEL is monitored with an optical configuration that does not introduce perturbation into the swept-source laser output spectrum that would cause an artifact in the OCT image.

Integration of various optoelectronic components is constrained by the size requirements. Another embodiment of the present invention provides a tunable laser assembly housed in a single enclosure wherein the center wavelength and tuning bandwidth of the tunable VCSEL is monitored and the VCSEL chip, monitor photodiodes, and temperature sensor all mounted on a common substrate.

Integration of various optoelectronics components in a small size also brings up the need for optical isolation between certain components to avoid reflections that can degrade performance or potentially damage the laser. Another embodiment of the present invention provides a tunable laser assembly housed in a single enclosure wherein optical isolation is achieved without employing a non-reciprocal, faraday-effect material.

One embodiment of the present invention provides a tunable laser assembly including: a tunable semiconductor laser chip emitting tunable laser radiation; a beam splitter; at least one wavelength monitoring optical element; at least one photodetector; a semiconductor optical amplifier; and at least one optical isolator; wherein the tunable semiconductor laser chip, the beam splitter, the at least one wavelength monitoring optical element, the at least one photodetector, the semiconductor amplifier, and the at least one optical isolator are mounted on a common baseplate; and wherein the at least one wavelength monitoring element generates a signal that is used to monitor and control at least one of the absolute wavelength and optical bandwidth of said tunable laser radiation.

One embodiment of the present invention provides a method for controlling the center wavelength and the optical bandwidth of swept-source tunable laser that using the timing information from a signal generated by a reference optical wavelength filter and an optical element that generates signal pulses corresponding to nearly equally spaced wavenumbers.

One embodiment of the present invention provides a stabilized laser including: a tunable semiconductor laser chip emitting tunable laser radiation; a beam splitter; at least one wavelength monitoring optical element; at least one photodetector; a semiconductor optical amplifier; at least one optical isolator; and a closed loop controller; wherein the tunable semiconductor laser chip, the beam splitter, the at least one wavelength monitoring optical element, the at least one photodetector, the semiconductor amplifier, and the at least one optical isolator are mounted on a common baseplate; and wherein the at least one wavelength monitoring optical element generates a signal that is input to the closed-loop controller and the closed-loop controller stabilizes the absolute wavelength and optical bandwidth of said tunable laser radiation.

One embodiment of the present invention provides a swept source optical coherence tomography system including: a stabilized laser including: a tunable semiconductor laser chip emitting tunable laser radiation; a beam splitter; at least one wavelength monitoring optical element; at least one photodetector; a semiconductor optical amplifier; at least one optical isolator; and a closed loop controller; wherein the tunable semiconductor laser chip, the beam splitter, the at least one wavelength monitoring optical element, the at least one photodetector, the semiconductor amplifier, and the at least one optical isolator are mounted on a common baseplate; and wherein the at least one wavelength monitoring optical element generates a signal that is input to the closed-loop controller and the closed-loop controller stabilizes the absolute wavelength and optical bandwidth of said tunable laser radiation; an optical coherence tomography (OCT) interferometer; and an OCT detector; wherein at least a portion of the said tunable laser radiation is directed to the OCT interferometer and the output of the OCT interferometer directed to an OCT detector for generating OCT interferograms.

### BRIEF DESCRIPTION OF THE DRAWINGS

Figure 1 is block diagram of tunable laser assembly according to prior art with fiber bragg grating based center wavelength monitoring.
Figure 2 is schematic diagram of highly stable, low cost, tunable laser assembly design according to an embodiment of the present invention.
Figure 3 shows the optical configuration and considerations for determining the dimensions of the beam splitter component.
Figure 4 shows a tunable laser assembly design according to another embodiment of the present invention.
Figure 5 shows a tunable laser assembly design according to another embodiment of the present invention.
Figure 6 shows a tunable laser assembly design according to another embodiment of the present invention.
Figure 7 shows a tunable laser assembly design according to another embodiment of the present invention.
Figure 8 shows a tunable laser assembly design according to another embodiment of the present invention.
Figure 9 shows a tunable laser assembly design according to another embodiment of the present invention.
Figure 10 shows a graph of sweep trajectories according to an embodiment.
Figure 11 shows a measure of the time required for the device to move from a starting wavenumber to an ending wavenumber according to an embodiment.
Figures 12A and 12B show the operation of a MEMS-VCSEL without and with optical bandwidth control respectively.
Figure 13 is a schematic diagram of a highly-stable tunable laser with a closed-loop controller according to an embodiment of the present invention.
Figures 14A and 14B are schematic diagrams of example swept source OCT systems.

### DETAILED DESCRIPTION OF THE PREFERRED EMBODIMENTS

The description of illustrative embodiments according to principles of the present invention is intended to be read in connection with the accompanying drawings, which are to be considered part of the entire written description. In the description of embodiments of the invention disclosed herein, any reference to direction or orientation is merely intended for convenience of description and is not intended in any way to limit the scope of the present invention. Relative terms such as "lower," "upper," "horizontal," "vertical," "above," "below," "up," "down," "top" and "bottom" as well as derivative thereof (e.g., "horizontally," "downwardly," "upwardly," etc.) should be construed to refer to the orientation as then described or as shown in the drawing under discussion. These relative terms are for convenience of description only and do not require that the apparatus be constructed or operated in a particular orientation unless explicitly indicated as such. Terms such as "attached," "affixed," "connected," "coupled," "interconnected," and similar refer to a relationship wherein structures are secured or attached to one another either directly or indirectly through intervening structures, as well as both movable or rigid attachments or relationships, unless expressly described otherwise. Moreover, the features and benefits of the invention are illustrated by reference to the exemplified embodiments. Accordingly, the invention expressly should not be limited to such exemplary embodiments illustrating some possible non-limiting combination of features that may exist alone or in other combinations of features; the scope of the invention being defined by the claims appended hereto.

This disclosure describes the best mode or modes of practicing the invention as presently contemplated. This description is not intended to be understood in a limiting sense, but provides an example of the invention presented solely for illustrative purposes by reference to the accompanying drawings to advise one of ordinary skill in the art of the advantages and construction of the invention. Although some elements disclosed herein are implemented on a chip or chipset without loss of generality, it is understood that many of these elements may also be implemented, for example, on one or more chips and/or one or more optical elements. In the various views of the drawings, like reference characters designate like or similar parts.

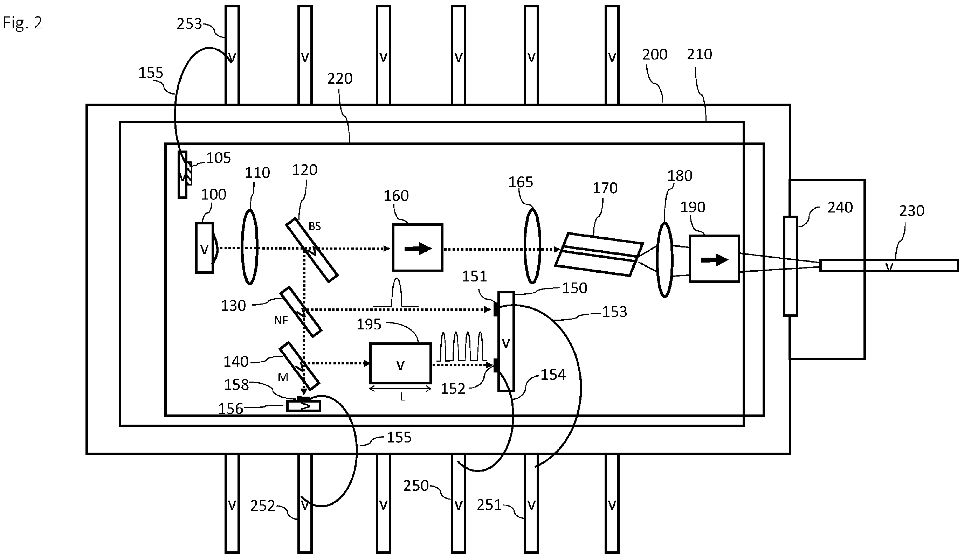

FIG. 2 is a schematic of a tunable laser assembly incorporating a tunable VCSEL chip, semiconductor amplifier chip and wavelength monitoring components all mounted to a common baseplate 220. The temperature of the baseplate is maintained through a feedback loop comprising a thermo-electric cooler (TEC) 210 and a temperature sensor 105 attached to the baseplate and connected to the external control circuit by an electrical connection 155 to an external package pin 253. As shown in FIG. 2, a tunable laser assembly according to an embodiment of the present invention includes an enclosure 200 containing a tunable VCSEL chip 100 and semiconductor optical amplifier (SOA) chip 170. Laser radiation from the tunable VCSEL is coupled into the SOA input waveguide via the collimating lens 110 and focusing lens 165. An optical isolator 160 is inserted between the VCSEL and SOA to prevent backwards propagating laser radiation from the SOA (e.g., amplified spontaneous emission (ASE) and/or amplified reflected signal) from setting up a potential laser cavity between the SOA and the top mirror on the tunable VCSEL chip. The amplified laser radiation from SOA output waveguide propagates through optical lens 180, through the window in the enclosure wall 240 and is coupled into the optical output fiber 230. An output optical isolator 190 is inserted between the SOA output and the optical fiber to prevent reflections from the optical fiber and components downstream of the optical from propagating back to the SOA.

In order to monitor both the absolute wavelength and the bandwidth of the tunable optical spectrum, two optical monitoring paths are provided that include wavelength monitoring optical elements comprised of a notch filter 130 and etalon 195 . A beam splitter 120 directs a portion of the laser radiation from the tunable VCSEL so that it is incident on notch filter (NF) 130 at an angle. The majority of the tunable optical spectrum is transmitted through the notch filter, except for a narrow band that is reflected and made incident on a photodetector 151. The signal from photodetector 151 is connected to an external absolute wavelength monitor circuit by an electrical connection 153 to an external package pin 251. The absolute wavelength is determined by reference to the narrow band notch reflection profile which can be calibrated against an external source. By holding the relative timing of the photo-detected narrow-band notch reflection profile relative to a known timing reference such as the electronic sweep trigger, the absolute wavelength of a specific portion of the tunable optical spectrum (e.g., the center wavelength) can be held constant in time relative to the trigger. The temperature dependence of the narrow-band notch reflection profile is minimized by TEC control of the baseplate temperature. Those skilled in the art will understand that control of the center wavelength doesn't mean that the exact center wavelength must be monitored, any portion of the tunable laser spectrum can used for the reference, although those wavelengths near the center are preferred as there is larger control signal. Those skilled in the art will also recognize that several methods exist for creating notch filters, that is, a filter that transmits the majority of its specified wavelength spectrum and highly reflects a narrow-band portion of the spectrum. Bragg grating are the most prevalent design for notch filters and can be implemented using conventional dielectric thin-film deposition or holographic techniques such as in Volume Holographic Gratings (VHG), which are also known as Volume Bragg Gratings (VBG). The optical-fiber version of a notch filter, a fiber Bragg gratings (FBG), has often been used in tunable lasers to provide an absolute wavelength reference for trigger/controlling the sweep. The advantage of the free-space notch filter in the present embodiments compared to an FBG, is the smaller size, compatibility with free-space integration, and the fact that it is temperature controlled simply by being mounted on the common baseplate with the other optical components. It is more difficult, bulky and expensive to temperature stabilize an FBG.

To monitor the bandwidth of the tunable optical spectrum (the 'optical bandwidth', or 'bandwidth'), the optical signal that is transmitted through the notch filter 130 is made incident at an angle on a partially-reflecting mirror (M) 140. The reflected signal from the mirror propagates through etalon 195, having a physical length L, and is made incident on a photodetector 152. The signal from photodetector 152 is connected to an external optical bandwidth monitor circuit by an electrical connection 154 to an external package pin 250. As the tunable VCSEL sweeps over the optical spectrum, the output signal from photodetector 152 consists of a series of pulses with the optical frequency spacing (Δf) between the adjacent maxima determined by the free spectral range (FSR) of the etalon: Δf = c/2nL, where c is the speed of light in vacuum and n is the index of refraction of the etalon. The corresponding wavelength spacing (Δλ) is given by Δλ = λ²/2nL, which is not constant but varies as the laser tunes. For a tunable laser operating with a center wavelength of 1300nm, the approximate wavelength spacing for an etalon made out of BK-7 glass (n = 1.5) and having L = 2.0 mm is 0.28 nm. Thus the series of pulses generated by the etalon provides a means to measure the bandwidth of the optical signal with a resolution determined by the FSR of the etalon. By controlling the timing of a defined number of pulses that occur relative to a known reference such as the internal sweep trigger or the absolute wavelength reference from the narrow-band notch filter reflection profile, the external circuit can control and hold constant the optical bandwidth of the tunable laser. Other materials that have higher refractive index than glass, such as LiNbO₃, GaAs, Si, or InP can be used for the etalon and have the advantage of more compact size and higher fringe contrast.

In addition to monitoring the absolute wavelength and the bandwidth of the tunable optical spectrum, it is also desirable to monitor the output power from the tunable VCSEL. A signal proportional to the optical output power can be obtained from etalon-generated signal from photodetector 152. However, to obtain a signal that is not distorted by the etalon, a partially-reflecting mirror 140, as shown in FIG. 2, transmits the full optical spectrum, minus the narrow-band notch reflection profile, to a photodetector 158. The signal from photodetector 158 is connected to an external optical bandwidth monitor circuit by an electrical connection 155 to an external package pin 252. In this embodiment, individual photodetectors 151 and 152 are shown mounted on a common substrate 150, whereas photodetector 158 is shown mounted individually on substrate 156. Those skilled in the art recognize that these drawings are only illustrative and many configurations of photodetectors exist, for example 151 and 152 could be a 2-element monolithic photodetector array mounted on a substrate, or all three photodetectors 151, 152, and 158 could be a 3-element array mounted on a substrate, or all three photodetectors 151, 152, and 158 could be individual photodetectors mounted on individual substrates.

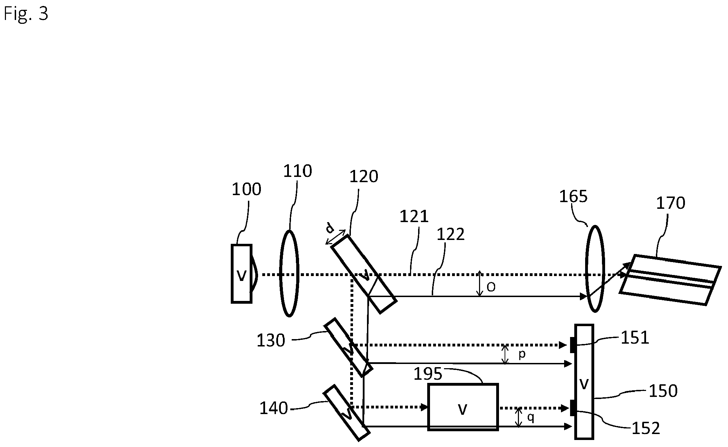

The wavelength monitoring optical elements must be designed to prevent introducing reflections in the optical path that create perturbations in the wavelength tuning spectrum. Any multiple propagation paths in the optical beam that make their way into the laser output signal will appear as artifacts in any OCT imaging system. The beam splitter 120 is particularly sensitive component as it is placed directly in the main laser beam optical path. In order to prevent multi-path reflections from the beam splitter, the beam splitter thickness must be large enough to prevent secondary reflections within the beam splitter from coupling into the laser output signal. In the embodiment shown in FIG. 3, the thickness, d, of the beam splitter 120 is chosen so that the secondary reflected beam 122 that is parallel with the main optical beam 121 has a large enough offset, O, that it does not effectively couple into SOA 170 because it arrives at the SOA input at an angle. For example, taking the beam splitter to be BK7 glass (n = 1.5) and assuming a propagating collimated gaussian beam having a mode field radius of approximately 170 um, a thickness of d = 0.75 mm or greater will provide more than 50dB rejection of the secondary beam coupling into the SOA amplifier chip. Secondary reflections from the beam splitter also can propagate into the wavelength monitoring circuit and distort the wavelength monitoring signals. The beam splitter thickness must be chosen so that the secondary beam offsets, p and q, are large enough so that the secondary beam does not add unwanted interference to the primary beam - either in the forward transmission or for detection by the wavelength monitoring photodetectors 151 and 152. A beam splitter thickness greater than or equal to 0.75mm is required to take advantage of readily available optical components to construct a practical design; such a thickness in BK7 glass can create a beam offset of approximately 570um which can readily suppress cross coupling between the primary and secondary beams to below -50dB with a suitable choice for the collimation lens 110.

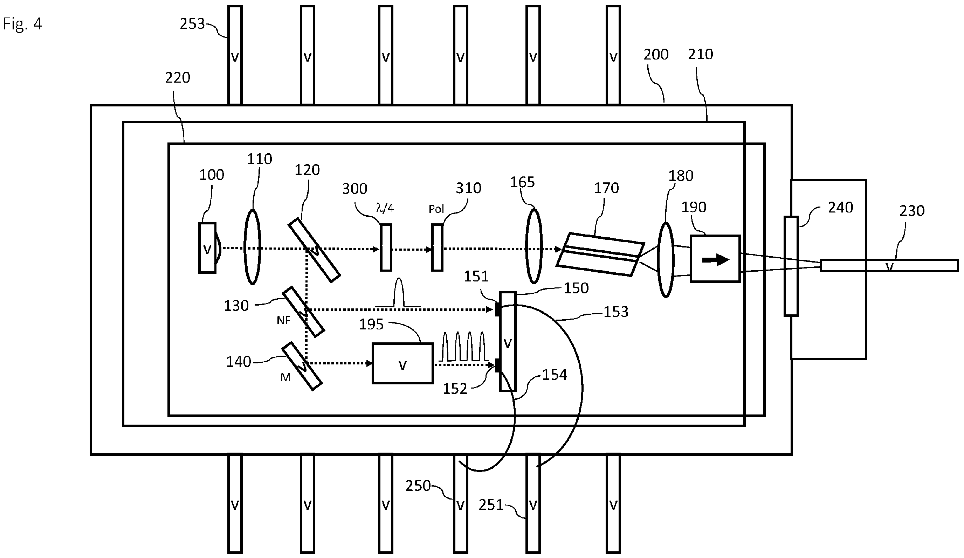

In another embodiment of the present invention, shown in FIG. 4, a quarter-wave polarization waveplate 300 and polarizer 310 are inserted between the VCSEL 100 and SOA 170 to prevent backwards propagating laser radiation from the SOA (e.g., amplified spontaneous emission (ASE) and/or amplified reflected signal) from setting up a potential laser cavity between the SOA and the top mirror on the tunable VCSEL chip. This combination of polarizer and quarter-wave polarization waveplate, which converts the linear polarized output light from the VCSEL to circular polarization, introduces a 3-dB loss in output power. However, it provides optical isolation between the SOA and VCSEL without the need for a Faraday rotator material, which is often expensive and can have high optical loss.

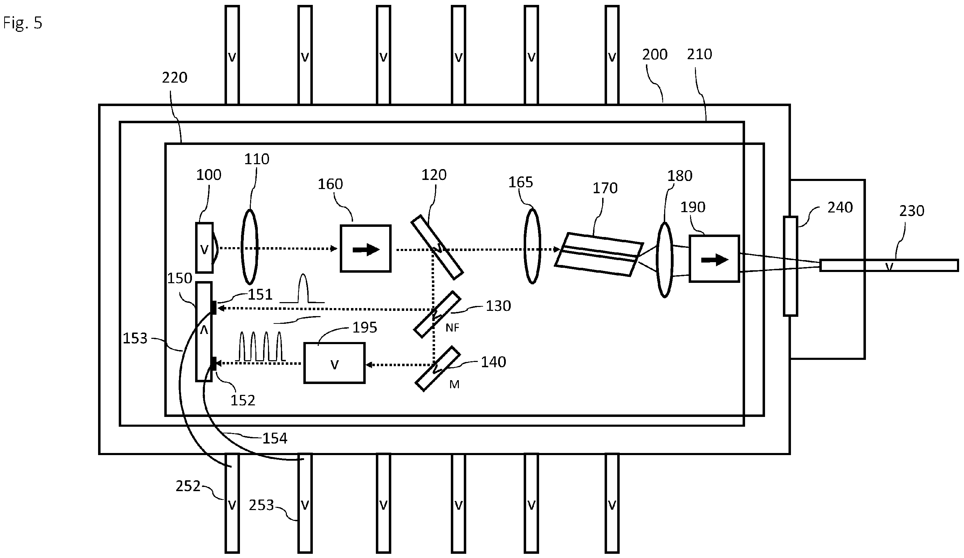

In another embodiment of the present invention, shown in FIG. 5, the optical isolator 160 is inserted in between the VCSEL 100 and the beam splitter 120. The advantage of this configuration is that, in addition to providing optical isolation between the VCSEL and SOA, the isolator reduces the effect of back-reflections from the wavelength monitoring components: filter, etalon, and photodetectors, from perturbing the VCSEL and generating artifacts.

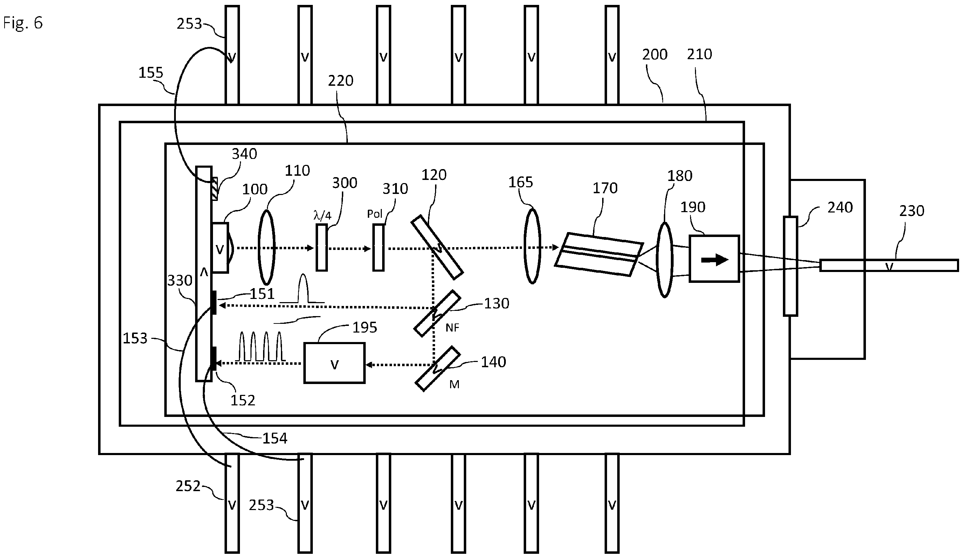

In another embodiment of the present invention, shown in FIG. 6, a quarter-wave polarization waveplate 300 and polarizer 310 are inserted between the VCSEL 100 and beam splitter 120. The advantage of this configuration is that, in addition to providing optical isolation between the SOA and VCSEL, the quarter-wave polarization waveplate/polarizer combination reduces the effect of back-reflections from the wavelength monitoring components: filter, etalon, and photodetectors, from perturbing the VCSEL and generating artifacts. This combination of polarizer and quarter-wave polarization waveplate, which converts the linear polarized output light from the VCSEL to circular polarization, introduces a 3-dB loss in output power. However, it provides optical isolation without the need for a Faraday rotator material, which is often expensive and can have high optical loss.

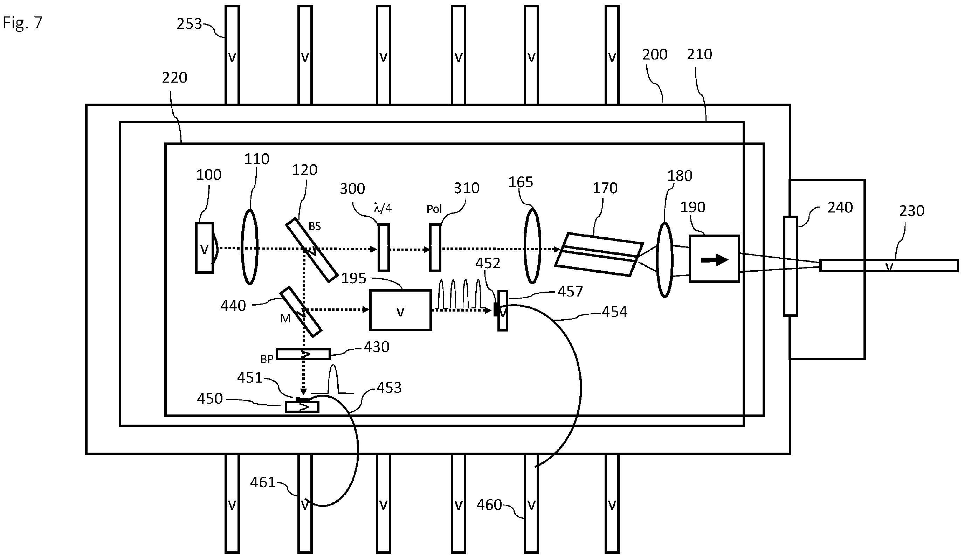

In another embodiment of the present invention, shown in FIG. 7, the notch filter 130 is replaced with a bandpass filter 430. The bandpass filter operates in transmission mode to generate the optical pulse used for center wavelength control, as compared to the notch filter which typically operates in reflection mode. The beam splitter 120 directs a portion of the laser radiation from the tunable VCSEL so that it is incident on a partially reflecting mirror (M) 440 at an angle. The mirror 440 reflects a portion of the laser radiation through an etalon 195 and is made incident on a photodetector 452. The signal from photodetector 452 is connected to an external optical bandwidth monitor circuit by an electrical connection 454 to an external package pin 460. The mirror transmits the remainder of the laser radiation through bandpass filter 430. The majority of the tunable optical spectrum is reflected or absorbed the bandpass filter, except for a narrow band that is transmitted and made incident on a photodetector 451. The signal from photodetector 451 is connected to an external absolute wavelength monitor circuit by an electrical connection 453 to an external package pin 461. The absolute wavelength is determined by reference to the narrow bandpass transmission profile which can be calibrated against an external source. By holding the relative timing of the photo-detected bandpass transmission profile relative to a known timing reference such as the sweep trigger generator, the absolute wavelength of a specific portion of the tunable optical spectrum (e.g., the center wavelength) can be held constant in time. The temperature dependence of the bandpass filter transmission profile is minimized by TEC control of the baseplate 220 temperature. Those skilled in the art will recognize that several methods exist for creating narrow optical bandpass filters, that is, a filter that reflects or absorbs the majority of its specified wavelength spectrum and transmits only a narrow-band portion of the spectrum. Multi-layer dielectric filters designed with coupled Fabry-Perot cavities are a common design, with bandpass filter shape that can be tailored by the selection of the number of Fabry-Perot cavities. The exact shape of the bandpass filter depends on many factors such as the laser sweep rate, bandwidth of the detection electronics, and allowed electrical jitter requirements for the generated trigger signal. The faster the transition rate of the electrical signal generated by detecting the laser tuning signal as it sweeps through the edge of the bandpass filter, or notch filter, the lower the jitter on the trigger signal. For a laser sweeping at a constant rate over a 100 nm optical bandwidth with a 100 kHz repetition rate and 70% duty cycle, a bandpass filter having a bandwidth of 1 nm @ FWHM and 10 nm @ -20 dB will generate a center wavelength pulse with a transition time of 4.5nm * (7us/100nm) = 315 ns. To keep the trigger jitter below 20 pm peak-to-peak, the optical filter must have sharp rolloff on the filter edge, which can be achieved with a filter have a bandwidth of 0.5 nm (FWHM) and 1 nm full-width @ -20 dB. For a bandpass filter, the bandwidth is the transmission bandwidth, for a notch filter, the bandwidth is the reflection bandwidth.

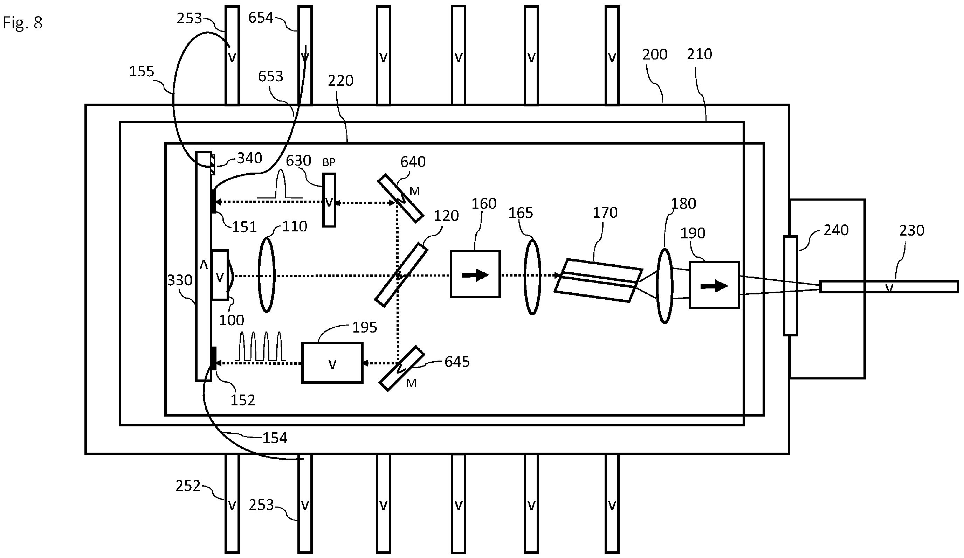

In another embodiment of the present invention, shown in FIG. 8, the out-of-band reflection from the bandpass filter 630 provides the signal that is incident on the etalon 195 and used for bandwidth monitoring. The beam splitter 120 directs a portion of the laser radiation from the tunable VCSEL so that it is incident on bandpass filter 630. A narrow-band spectrum of the laser radiation is transmitted through the bandpass filter and is made incident on a photodetector 151. The signal from photodetector 151 is connected to an external absolute wavelength monitor circuit by an electrical connection 653 to an external package pin 654. The absolute wavelength is determined by reference to the narrow bandpass transmission profile which can be calibrated against an external source. The bandpass filter is designed so that the majority of the tunable laser radiation spectrum is reflected from the bandpass filter. This reflected signal passes back through the beam splitter 120 and passes through etalon 195 and is made incident on a photodetector 152. The signal from photodetector 152 is connected to an external optical bandwidth monitor circuit by an electrical connection 154 to an external package pin 253. In this compact embodiment, turning mirrors 640 and 645 enable the photodetectors 151 and 152, the VCSEL chip, and the temperature sensor 340 to be attached to a common substrate 330. Those skilled in the art will recognize that other optical configurations are possible that do not use turning mirrors and where the photodetectors, VCSEL chip and temperature sensor do not share a common substrate.

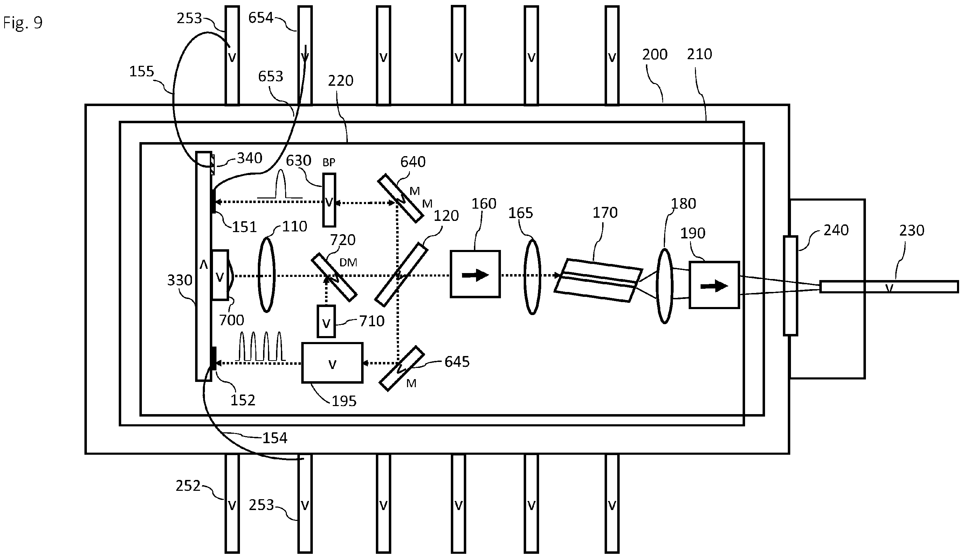

In another embodiment of the present invention, shown in FIG. 9, the tunable VCSEL chip 700 is optically pumped by the pump laser 710. The pump radiation is directed to the VCSEL chip via the dichroic mirror (DM) 720, which is substantially reflecting at the pump wavelength (e.g., 780nm, 850nm, 980 nm, 1300 nm) but transmits the broadband VCSEL signal wavelengths (e.g., 1000-1100m, 1250-1350 nm, 1450-1600 nm). The dichroic mirror is located between the VCSEL chip 700 and the beam splitter 120 that taps off a portion of the tunable laser radiation in order to implement the optical wavelength monitoring functions. Those skilled in the art will recognize that other optical configurations are possible, for example, the beam splitter could be located between the VCSEL chip and the dichroic mirror. Alternatively, the VCSEL chip could be optically pumped from the backside of the chip, eliminating the need for the dichroic mirror. It is well known that the quality of the tunable laser emission depends on the quality of the pump laser. For demanding applications such as OCT, the pump laser needs to be a single-frequency laser such as a distributed feedback (DFB), distributed Bragg reflector (DBR), Y-branch, or other external cavity laser such a volume holographic grating (VHG) stabilized laser.

There are several possible methods to use the signals generated by the notch/bandpass filter and etalon to control the absolute wavelength (center wavelength) and tuning optical bandwidth, respectively. Open loop operation of a MEMS-VCSEL swept laser source presents many challenges in maintaining a stable output over long operating time frames and/or changing environmental conditions. Long term charging effects in the MEMS structure lead to changes in the effective voltage that is applied to the device. As the MEMS structure is an electrostatically controlled moving membrane the relationship between the voltage on the electrodes and the mirror position is highly nonlinear. Slight changes in operating DC level can result in large changes to the sweep profile and ultimately the overall bandwidth that is contained within a given time window. Additionally, the mechanical damping of the device is highly sensitive to the surrounding environment. Open-loop calibration/corrections can be applied, but these require extensive production characterization procedures and long-term testing.

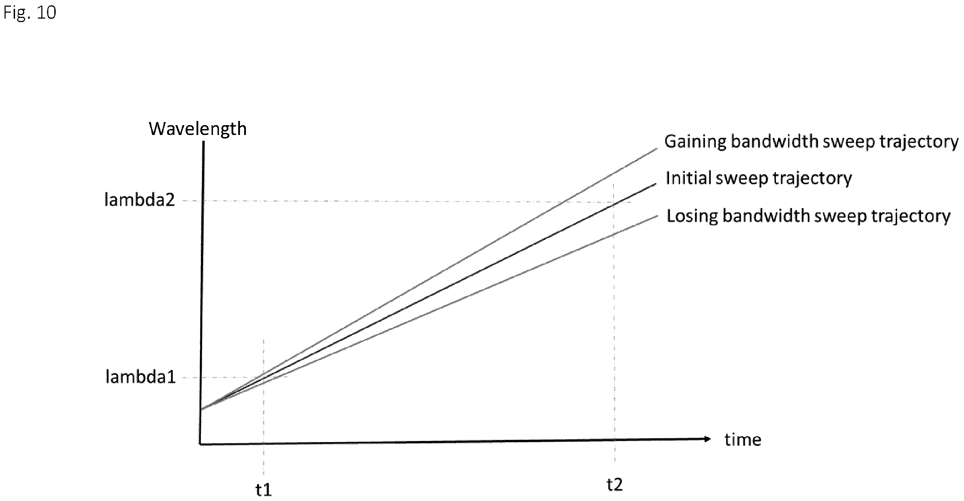

To enable robust and long-term operation it is desired that an optical reference signal be used to monitor and subsequently control the high voltage drive signals to the tunable MEMS-element such that the swept bandwidth is maintained under all operating conditions and timeframes. This optical signal is used to generate timing information which has a direct correlation to the optical bandwidth and overall sweep trajectory. The typical mechanism for bandwidth loss or gain is mainly that the sweep velocity changes, as illustrated in FIG. 10. As the defined active sweep period is typically fixed by other system parameters, any shift in the sweep velocity directly results in a change in the overall sweep bandwidth within a given time window. Under this assumption, it can be shown that controlling the time difference (t2-t1 in FIG. 10) required to sweep a defined bandwidth (lambda2-lambda1 in FIG. 10) is sufficient to maintaining the overall bandwidth of the tunable swept-source MEMS-VCSEL.

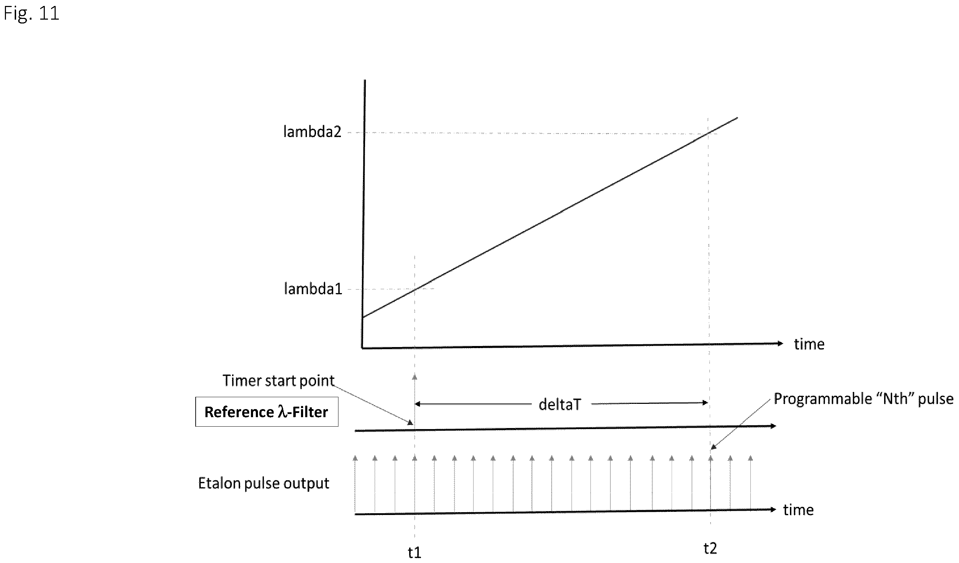

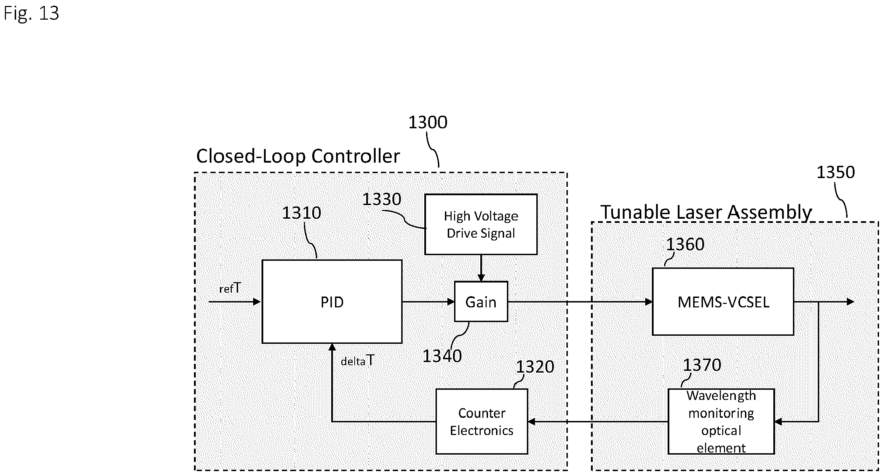

An optical etalon can be used to generate electrical pulses (via zero crossing detection) each of which corresponds to nearly equally spaced wavenumbers. An electronic counter circuit can then be used to generate a measure of the time (deltaT) required for the device to move from a starting wavenumber to an ending wavenumber, as shown in FIG. 11. The counter electronics combined with the etalon allow a very fine resolution and adjustable timing "marker" to be placed at an ideal location within the sweep trajectory by selecting a programmable 'Nth' pulse as the control marker. This implementation for marking the sweep end-point is highly advantageous compared to using fixed wavelength references (notch filter, bandpass filter) which are not flexible enough to select a proper end-point for all MEMS-VCSEL devices, due to variation in absolute sweep wavelength, difference in sweep rates, and/or different bandwidth requirements. For ensuring absolute wavelength accuracy, the timer starting point (t1, lambda1) is generated by the Reference λ-Filter (i.e. the notch or bandpass filter) while the second timing marker (t2) is generated by the etalon, selecting the appropriate 'Nth' pulse to use for bandwidth control. The deltaT generated by the counter electronics 1320 may be used as feedback in a proportional-integral-derivative control algorithm (PID) to implement a closed-loop controller 1300, as shown in FIG. 13. The PID 1310 measures the difference between the deltaT and a reference time corresponding to the desired bandwidth (refT). Tuning coefficients are applied to this difference generating a PID output that adjusts the gain 1340 of the high voltage signal 1330 driving the MEMS-VCSEL 1360 in the tunable laser assembly 1350. This minimizes the difference between deltaT and refT, maintaining the desired optical bandwidth. This same method can be applied for use in any type of tunable swept source laser and is not limited to the integrated optical assembly embodiments in this disclosure. For example, an FBG can be used as the Reference λ-Filter and a Mach-Zehnder Interferometer (MZI) or FBG having multiple reflection peaks may be used in a similar manner as the etalon to obtain the same timing information for the follow-on control algorithms.

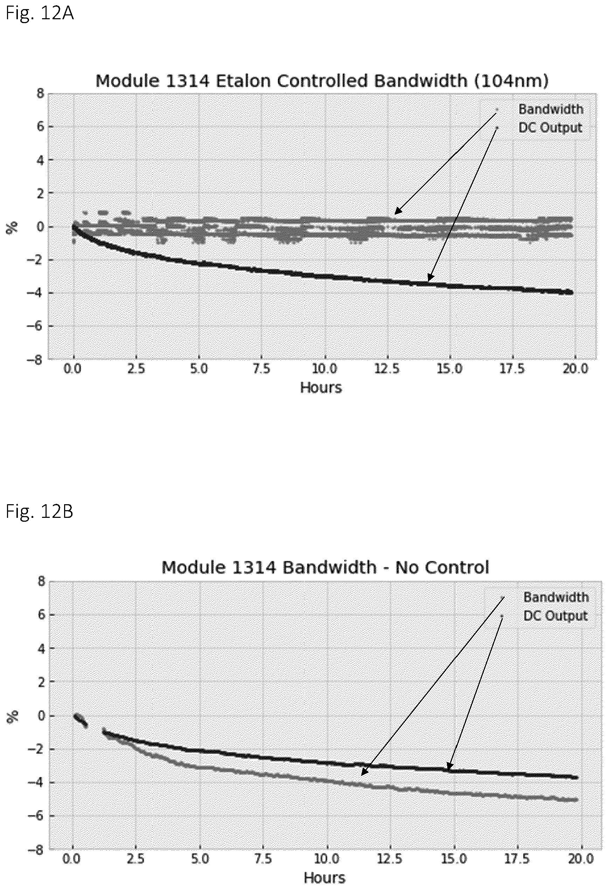

The application of the optical bandwidth control method described in the preceding sections is demonstrated in FIGS. 12A and 12B, which show operation of a MEMS_VCSEL without and with bandwidth control. Without bandwidth control, there is a change in bandwidth of approximately -5% over 20 hours as the DC bias operating point slowly drifts (FIG. 12A). This change in bandwidth is eliminated with bandwidth control method engaged (FIG. 12B).

Optical Coherence Tomography (OCT) is a non-invasive, interferometric optical imaging technique that can generate micron resolution 2D and 3D images of tissue and other scattering or reflective materials. With applications in medicine, biological research, industrial inspection, metrology, and quality assurance, OCT can be used for subsurface imaging, surface profiling, motion characterization, fluid flow characterization, index of refraction measurement, birefringence characterization, scattering characterization, distance measurement, and measurement of dynamic processes. The most common implementation of OCT is spectral / Fourier domain OCT (SD-OCT), which uses a broadband light source, interferometer, and spectrometer. An alternate implementation of OCT is swept source OCT (SS-OCT). SS-OCT uses a tunable laser (sometimes called a wavelength swept laser), interferometer, OCT detector, and high speed analog to digital (A/D) converter. The tunable laser sweeps an emission wavelength in time which is used as input to an OCT interferometer. An OCT interferogram is formed by interfering and detecting light from a sample arm with light from a reference arm in the OCT interferometer, which is detected by the OCT detector and digitized by the A/D converter. Processing the digitized interferogram generates a reflectivity vs. depth profile of the sample, called an A-scan. Multiple A-scans can be obtained to generate two dimensional OCT images or three dimensional OCT volumes.

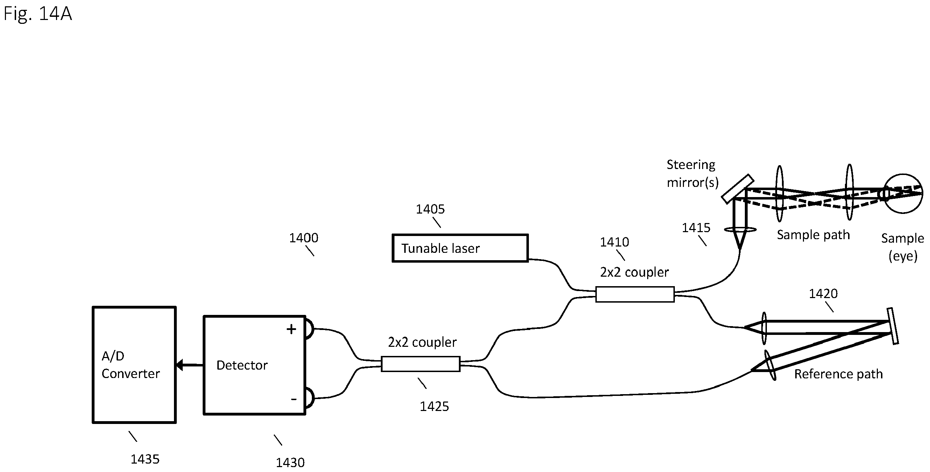

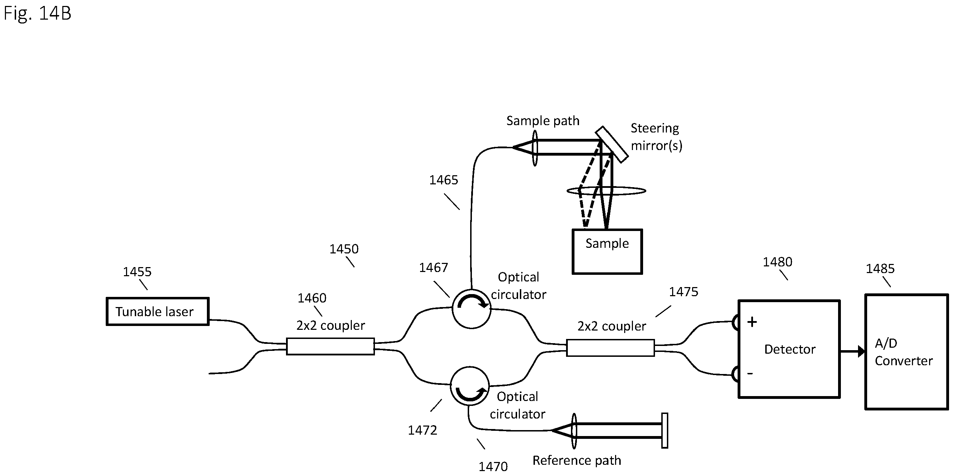

FIGS. 14A and 14B show schematic diagrams of example swept source OCT systems. Depending on the wavelength of operation, a coupler based or combined coupler and circulator based interferometer might be preferred. FIG. 14A shows a swept source OCT system 1400 in which light from a tunable laser 1405 is directed to a coupler 1410 which splits light between a sample path 1415 and a reference path 1420. Light from the sample path 1415 and light from the reference path 1420 are combined at a path interfering element 1425 and directed to an OCT detector 1430. The electrical signal from the OCT detector 1430 is digitized by the A/D converter 1435. FIG. 14B shows a swept source OCT system 1450 in which light from a tunable laser 1455 is directed to a coupler 1460 which splits light between a sample path 1465 including an optical circulator 1467 and a reference path 1470 including an optical circulator 1472. Light from the sample path 1465 and light from the reference path 1470 are combined at a path interfering element 1475 and directed to an OCT detector 1480. The electrical signal from the OCT detector 1480 is digitized by the A/D converter 1485. While FIG. 14 shows common OCT system topologies, other OCT system topologies are possible including using various combinations of couplers and optical circulators not shown in FIG 14. Components in a SS-OCT system may be any one of or any combination of fiber optic components, free space components, photonic integrated circuits (PIC), and planar lightwave circuits (PLC).

The present invention has been described at some length and with some particularity with respect to the several described embodiments, it is not intended that it should be limited to any such particulars or embodiments or any particular embodiment, but it is to be construed with references to the appended claims so as to provide the broadest possible interpretation of such claims in view of the prior art and, therefore, to effectively encompass the intended scope of the invention. Furthermore, the foregoing describes the invention in terms of embodiments foreseen by the inventor for which an enabling description was available, notwithstanding that insubstantial modifications of the invention, not presently foreseen, may nonetheless represent equivalents thereto.

### References:

[1] US 6,362,878 B1, Wang, "Multipoint Wavelength Calibration Technique".
[2] Keysight Technologies, Data Sheet, 5988-8518EN, December 2017.
[3] US 6,486,984 B1, Baney, "Wavelength Monitor Using Hybrid Approach".
[4] US 5,850,292, Braun, "Wavelength Monitor for Optical Signals".
[5] US 6,043,883, Leckel, "Wavemeter and an Arrangement for the Adjustment of the Wavelength of the Signals of an Optical Source".
[6] H. Nasu, 'Wavelength Monitor Integrated Laser Modules for 25-GHz Spacing Tunable Applications", IEEE J. Sel. Topics Quantum Electron., Vol. 11, No. 1, 2005, pp. 157- 164.
[7] US 6,498,800 B1, Watterson, "Double Etalon Optical Wavelength Reference Device".
[8] US 6,594,022 B1, Watterson, "Wavelength Reference Device".
[9] R. Yu, "Rapid High-Precision In Situ Wavelength Calibration for Tunable Lasers Using an Athermal AWG and a PD Array", IEEE Photon. Technol. Lett., Vol. 24, No. 1, 2012, pp. 70-72.
[10] US 5,982,791, Sorin, "Wavelength Tracking in Adjustable Optical Systems".
[11] SL10 and SL13 Series MEMS-VCSEL Swept Sources - User Manual, www.thorlabs.com

## Claims

1. A tunable laser assembly comprising:
a tunable semiconductor laser emitting tunable laser radiation;
a beam splitter;
at least one wavelength monitoring optical element;
at least one photodetector;
a semiconductor optical amplifier; and
at least one optical isolator;
wherein the tunable semiconductor laser, the beam splitter, the at least one wavelength monitoring optical element, the at least one photodetector, the semiconductor amplifier, and the at least one optical isolator are mounted on a common baseplate; and wherein the at least one wavelength monitoring element generates a signal that is used to monitor at least one of the absolute wavelength and optical bandwidth of said tunable laser radiation.

2. The tunable laser assembly of claim 1, wherein said tunable semiconductor laser is a tunable micro-electro-mechanical system-vertical cavity semiconductor laser (MEMS-VCSEL).

3. The tunable laser assembly of claim 1, wherein said beam splitter is configured to direct a portion of said tunable laser radiation to said at least one wavelength monitoring optical element without introducing reflection artifacts in the laser output.

4. The tunable laser assembly of claim 1, wherein said beam splitter has a thickness greater than 0.75 mm.

5. The tunable laser assembly of claim 1, wherein said at least one wavelength monitoring optical element comprises a notch filter.

6. The tunable laser assembly of claim 1, wherein said at least one wavelength monitoring optical element comprises a notch filter and an etalon.

7. The tunable laser assembly of claim 1, wherein said at least one photodetector comprises at least two photodetectors mounted on a common substrate.

8. The tunable laser assembly of claim 7, wherein said at least two photodetectors comprise elements of a monolithic multi-element array.

9. The tunable laser assembly of claim 1, wherein said tunable semiconductor laser and said at least one photodetector are mounted on a common substrate.

10. The tunable laser assembly of claim 1, wherein said at least one wavelength monitoring optical element comprises a bandpass filter.

11. The tunable laser assembly of claim 1, wherein said at least one wavelength monitoring optical element comprises a bandpass filter and an etalon.

12. The tunable laser assembly of claim 1, wherein said at least one photodetector comprises at least two photodetectors mounted on a common substrate.

13. The tunable laser assembly of claim 12, wherein said at least two photodetectors comprise elements of a monolithic multi-element array.

14. The tunable laser assembly of claim 1, wherein said tunable semiconductor laser and said at least one photodetector are mounted on a common substrate.

15. The tunable laser assembly of claim 1, wherein said at least one optical isolator is located between the said tunable semiconductor laser and the said beam splitter.

16. The tunable laser assembly of claim 1, wherein said at least one optical isolator comprises a quarter-wave polarization waveplate and a polarizer.

17. The tunable laser assembly of claim 1, wherein said at least one wavelength monitoring optical element provide pulses that enable control of the absolute wavelength and optical bandwidth of said laser radiation by observing the timing and number of the pulses as the laser sweeps across the wavelength range.

18. The tunable laser assembly of claim 1, wherein the temperature of said common baseplate is maintained through a feedback loop comprising a thermo-electric cooler (TEC) and a temperature sensor attached to said common baseplate.

19. The tunable laser assembly of claim 1, wherein said tunable semiconductor laser is optically pumped.

20. The tunable laser assembly of claim 19, wherein said tunable semiconductor laser is optically pumped by a single-frequency laser.

21. The tunable laser assembly of claim 20, wherein said single-frequency pump laser comprises one of a distributed feedback laser (DFB), a distributed Bragg reflector laser (DBR), a Y-branch laser, or a volume holographic grating (VHG) stabilized laser.

22. The tunable laser assembly of claim 19, wherein said tunable semiconductor laser is an optically pumped MEMS-VCSEL.
